# EUROPÄISCHE PATENTSCHRIFT

(11) **EP 2 062 301 B1**
(45) Veröffentlichungstag und Bekanntmachung des Hinweises auf die Patenterteilung: **03.04.2019**
(21) Anmeldenummer: 08706734.4
(22) Anmeldetag: 09.01.2008
(51) Int. Cl.: H01L 25/16, H01L 33/48, H01L 31/0203, H01L 33/60

(54) **GEHÄUSE FÜR OPTOELEKTRONISCHES BAUELEMENT UND ANORDNUNG EINES OPTOELEKTRONISCHEN BAUELEMENTES IN DEM GEHÄUSE**
HOUSING FOR AN OPTOELECTRONIC COMPONENT AND ARRANGEMENT OF AN OPTOELECTRONIC COMPONENT IN THE HOUSING
BOÎTIER POUR COMPOSANT OPTOÉLECTRONIQUE ET DISPOSITION D'UN COMPOSANT OPTOÉLECTRONIQUE DANS LE BOÎTIER

(30) Priorität: 11.01.2007 DE 102007001706
(43) Veröffentlichungstag der Anmeldung: 27.05.2009
(73) Patentinhaber: OSRAM Opto Semiconductors GmbH, 93055 Regensburg (DE)
(72) Erfinder: BOGNER, Georg, 93138 Lappersdorf (DE); GRUBER, Stefan, 93077 Bad Abbach (DE); ZEILER, Thomas, 93152 Nittendorf (DE); KIRSCH, Markus, 93164 Brunn (DE)
(74) Vertreter: Epping - Hermann - Fischer
(86) Internationale Anmeldenummer: PCT/DE2008/000029
(87) Internationale Veröffentlichungsnummer: WO 2008/083672

(56) Entgegenhaltungen:
- EP-A- 1 622 237
- WO-A-2004/068594
- WO-A-2005/104248
- WO-A-2006/111907
- WO-A-2006/114082
- WO-A-2008/031391
- WO-A2-03/038912
- DE-A1- 10 340 069
- DE-A1-102004 031 391
- DE-A1-102004 045 950
- DE-U1- 8 424 611
- JP-A- 2003 008 075
- JP-A- 2006 216 887
- US-A1- 2002 163 001
- US-A1- 2005 121 686
- US-A1- 2005 180 698
- US-A1- 2006 267 040
- US-A1- 2007 001 177

## Beschreibung

Die vorliegende Erfindung betrifft ein Gehäuse für ein optoelektronisches Bauelement, das insbesondere als Linsenbauelement für Leuchtdioden verwendet werden kann.

Für elektronische Bauelemente wird eine Vielzahl verschiedener Gehäuse verwendet. Halbleiterchips werden vielfach auf strukturierten metallischen Trägern, so genannten Leadframes, montiert und in eine Vergussmasse eingespritzt. Bei so genannten QFN-Bauelementen (Quad Flat No Lead) wird als Gehäuse ein flacher quadratischer Duroplastkörper verwendet, der lichtundurchlässig ist. Für optoelektronische Bauelemente kann ein lichtdurchlässiges Gehäuse aus einem Thermoplastmaterial verwendet werden. Ein Konversionselement, das für eine Modifizierung des abgestrahlten Lichts vorgesehen ist, wird bei Verwendung derartiger Gehäuse zum Beispiel für Leuchtdioden (LED) unmittelbar auf dem Chip des optoelektronischen Bauelementes angebracht.

Die Druckschrift DE 103 40 069 A1 beschreibt eine oberflächenbefestigbare Elektronikvorrichtung mit einem Körper mit einem Hohlraum, in dem zwei LEDs angeordnet sind. Diese Druckschrift beschreibt in einem Beispiel die Anordnung von zwei LED-Chips auf einem ebenen metallischen Leadframe, dessen Rückseite Kontaktflächen für einen externen elektrischen Anschluss bildet.

Die Druckschrift JP 2006-216887 A beschreibt ein optoelektronisches Bauelement mit einem Substrat, auf dem eine Fotodiode und ein IC auf elektrisch leitenden Strukturen angeordnet sind. Auf dem Substrat ist ein Reflektor mit einer Öffnung aufgebracht, in der die Fotodiode angeordnet ist, wobei der IC in das Kunstharzmaterial des Reflektors eingebettet ist, das optional schwarz ist.

Aufgabe der vorliegenden Erfindung ist es, ein Gehäuse für optoelektronische Bauelemente anzugeben, das besser als bisherige Gehäuse mit optischen Komponenten kombiniert werden kann. Insbesondere soll eine in dem Gehäuse montierte Leuchtdiode einen niedrigen Wärmewiderstand und eine hohe thermisehe Stabilität aufweisen und auf zweckmäßige Weise mit einem Konversionselement versehen werden können.

Diese Aufgabe wird mit dem Gehäuse mit den Merkmalen des Anspruches 1 bzw. mit der Anordnung eines optoelektronischen Bauelementes in einem Gehäuse mit den Merkmalen des Anspruchs 8 gelöst, wobei die vorliegende Erfindung in Anspruch 1 definiert ist.

Ausgestaltungen ergeben sich aus den jeweiligen abhängigen Ansprüchen.

Das Gehäuse weist ein Trägerelement auf, auf dem ein Kunststoffgehäuse angeordnet ist, das insbesondere ein Duroplast und lichtundurchlässig sein kann. Das Kunststoffgehäuse ist mit einer Aussparung versehen, die zur Aufnahme eines optoelektronischen Bauelementes vorgesehen ist und auf der von dem Trägerelement abgewandten Seite eine Öffnung nach außen aufweist. Ein optoelektronisches Bauelement wird mit einem für Lichtemission oder Lichtrezeption vorgesehenen Bereich zu der Öffnung hin ausgerichtet innerhalb der Aussparung angeordnet. Die Aussparung kann insbesondere nach der Montage des optoelektronischen Bauelementes mit einem transparenten Füllmaterial aufgefüllt werden. Eine transparente Abdeckung der Aussparung kann im Bereich der Öffnung, insbesondere im Abstand zu einem in der Aussparung angeordneten optoelektronischen Bauelement, angeordnet sein. Die Abdeckung kann zum Beispiel ein transparenter Deckel aus Glas oder Kunststoff sein, aber auch eine Linse oder eine Anordnung verschiedener optischer Komponenten umfassen.

In der Aussparung kann ein Konversionselement zur Modifizierung des Lichts angeordnet werden, insbesondere bei Anwendungen für Leuchtdioden. Die Gehäuseform gestattet es, das Konversionselement in einem geeigneten Abstand zu der lichtemittierenden Oberseite des Bauelementes anzuordnen. Das Konversionselement kann dafür vorgesehen sein, die Farbe des Lichts zu verändern. Es ist vorzugsweise möglichst dünn, überspannt vorzugsweise den gesamten durch die Öffnung der Aussparung bestimmten Raumwinkelbereich und ist vorzugsweise nicht in direktem Kontakt mit dem optoelektronischen Bauelement angeordnet. Dadurch wird gewährleistet, dass das in verschiedene Richtungen emittierte Licht beim Durchqueren des Konversionselementes etwa dieselbe Weglänge zurücklegt und folglich unabhängig von der Abstrahlrichtung eine ähnliche Farbtemperatur aufweist.

An dem Kunststoffgehäuse können gesondert vorgesehene Strukturen oder Montageöffnungen vorhanden sein, welche die Anordnung einer Abdeckung oder optischer Komponenten relativ zu dem Kunststoffgehäuse festlegen und so eine einfache Montage einer Abdeckung oder optischer Komponenten und deren präzise Ausrichtung relativ zu dem Kunststoffgehäuse ermöglichen. Für die Montage des optoelektronischen Bauelementes, insbesondere einer Leuchtdiode (LED), kann an dem Trägerelement auf der der Aussparung zugewandten Seite eine Chipinsel oder dergleichen vorgesehen sein. Zur Ausrichtung des optoelektronischen Bauelementes können zusätzliche Strukturelemente auf dem Trägerelement vorgesehen werden.

Ein elektrischer Anschluss des optoelektronischen Bauelementes wird durch Verwendung eines Trägerelementes aus Metall und eine geeigneten Strukturierung des Trägerelementes vorgesehen. Das Trägerelement ist eine strukturierte Metallschicht, nämlich ein an sich bekannter Leadframe, der in getrennte Anteile, die elektrisch voneinander isoliert sind, aufgeteilt ist. Ein solches Trägerelement kann z. B. aus Kupfer bestehen. Das optoelektronische Bauelement wird dann z. B. über einen Rückseitenkontakt auf der Chipinsel des Trägerelementes kontaktiert. Für den weiteren elektrischen Anschluss kann z. B. ein Bonddraht vorgesehen sein, der einen entsprechenden Anschlusskontakt des optoelektronischen Bauelementes mit einem weiteren Anteil des Trägerelementes elektrisch leitend verbindet. Die verschiedenen Anteile des strukturierten Trägerelementes aus Metall bilden so den externen elektrischen Anschluss an dem Gehäuse. Das Gehäuse braucht erfindungsgemäß nicht mit nach außen geführten streifenförmigen Anschlussleitern ("Anschlussbeinchen") versehen zu sein (no leads). Die rückseitigen Kontaktflächen des Trägerelementes können für einen externen elektrischen Anschluss zum Beispiel auf einer Platine oder dergleichen aufgelötet werden.

Das Material des Kunststoffgehäuses ist im Hinblick auf den thermischen Ausdehnungskoeffizienten und die Haftungseigenschaften an das Material des Trägerelementes angepasst. Durch den Verbund mit einem Kunststoffgehäuse aus geeignetem Material ist es möglich, als Trägerelement einen ebenen metallischen Leadframe zu verwenden, der lediglich gestanzt oder geätzt ist und im Verbund mit dem Kunststoffgehäuse trotzdem eine hohe mechanische Stabilität aufweist. Innerhalb des Kunststoffgehäuses, d.h. eingespritzt in das Kunststoffmaterial des Kunststoffgehäuses, ist mindestens ein weiteres elektronisches Bauelement als ESD-Schutz oder als Ansteuerbauelement angeordnet.

Diese Gehäuseform erlaubt es, eine Anordnung optoelektronischer Bauelemente in einem Gehäuse zu realisieren, die mechanisch und thermisch stabil ist und außerdem mit unterschiedlichen weiteren optischen und/oder elektrischen Komponenten versehen sein kann.

Es folgt eine genauere Beschreibung von Beispielen und Ausführungsbeispielen des Gehäuses anhand der beigefügten Figuren.
Die Figur 1 zeigt ein Beispiel des Gehäuses in einer Aufsicht.
Die Figur 2 zeigt das Beispiel gemäß der Figur 1 in einer rückseitigen Aufsicht.
Die Figur 3 zeigt den in der Figur 1 markierten Querschnitt.
Die Figur 4 zeigt einen der Figur 3 entsprechenden Querschnitt für ein weiteres Beispiel.
Die Figur 5 zeigt den in der Figur 1 markierten weiteren Querschnitt für ein Ausführungsbeispiel.
Die Figur 6 zeigt einen der Figur 5 entsprechenden Querschnitt für ein weiteres Ausführungsbeispiel.
Die Figur 7 zeigt ein weiteres Ausführungsbeispiel des Gehäuses in einer Aufsicht.
Die Figur 8 zeigt das Ausführungsbeispiel gemäß der Figur 7 in einer rückseitigen Aufsicht.

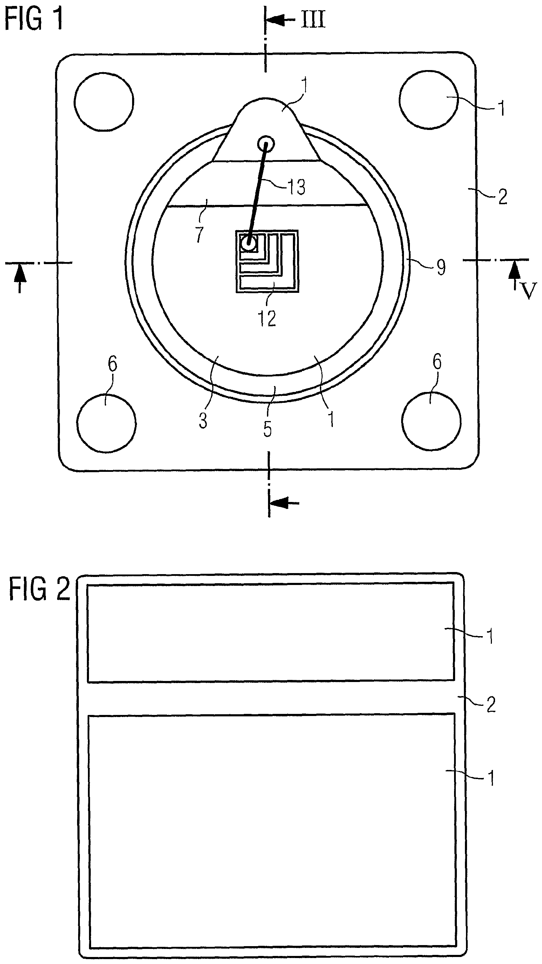

Die Figur 1 zeigt eine Aufsicht auf ein Beispiel des Gehäuses. Auf einem Trägerelement 1 ist ein Kunststoffgehäuse 2 angebracht, das Aussparungen aufweist, durch die in der in der Figur 1 wiedergegebenen Blickrichtung Anteile des Trägerelementes 1 von oben sichtbar sind. Diese Aussparungen können, soweit sie nicht zur Aufnahme eines optoelektronischen Bauelementes vorgesehen sind, sondern nur Montagehilfen darstellen, auch weggelassen sein; sie müssen auch nicht bis auf die Oberseite des Trägerelementes 1 hinab reichen. Das Kunststoffgehäuse 2 kann lichtundurchlässig, z. B. schwarz, und insbesondere ein Duroplast sein, wie er z. B. bei konventionellen QFN-Gehäusen verwendet wird. Das Kunststoffgehäuse 2 weist eine Aussparung 3 auf, die vorzugsweise achsensymmetrisch, in dem dargestellten Ausführungsbeispiel zumindest näherungsweise zylindrisch ist, aber grundsätzlich jede beliebige geometrische Form aufweisen kann. Auf der von dem Trägerelement 1 abgewandten Seite weist die Aussparung eine Öffnung 9 nach außen auf, durch die Licht hindurchtreten kann.

Innerhalb der Aussparung 3 wird ein optoelektronisches Bauelement 12 über dem Trägerelement 1 angeordnet. Das optoelektronische Bauelement 12 kann zum Beispiel unmittelbar auf einer Chipinsel des Trägerelementes 1 angeordnet sein. In diesem Fall wird vorzugsweise ein erster elektrischer Anschluss über einen Rückseitenkontakt des optoelektronischen Bauelementes 12 mit dem Trägerelement 1 bewirkt. Ein weiterer elektrischer Anschluss wird in dem in der Figur 1 dargestellten Beispiel durch einen Bonddraht 13 gebildet, der einen Anschlusskontakt des optoelektronischen Bauelementes 12 mit einer Anschlussfläche eines weiteren Anteils des Trägerelementes verbindet. Die Anteile des Trägerelementes 1 sind in dem dargestellten Beispiel durch einen nicht notwendig vorhandenen Steg 7 getrennt und voneinander elektrisch isoliert, wobei dieser Steg 7 von einem Anteil des Kunststoffgehäuses 2 gebildet sein kann.

Eine Struktur 5 des Kunststoffgehäuses 2 kann vorgesehen sein, damit auf der Aussparung 3 eine Abdeckung oder eine optische Komponente, zum Beispiel ein Konversionselement, relativ zu dem Kunststoffgehäuse 2 präzise ausgerichtet werden kann oder damit eine bessere Haftung einer transparenten Vergussmasse erreicht wird. Für optische Komponenten, die in einer Abdeckung vorgesehen sind, können in dem Kunststoffgehäuse 2 zudem Montageöffnungen 6 oder Nuten angebracht sein, in die z. B. Stifte oder dergleichen Fortsätze, die an der betreffenden optischen Komponente angebracht sind, eingepasst werden. Das optoelektronische Bauelement 12 kann z. B. eine Leuchtdiode (LED) oder ein anderes lichtemittierendes Bauelement sein. Es ist ebenso möglich, einen Fotodetektor in dem Gehäuse anzuordnen.

Die Figur 2 zeigt das Gehäuse des Beispiels der Figur 1 in einer Rückansicht. In dem dargestellten einfachen Beispiel besitzt das Trägerelement 1 zwei voneinander getrennte und elektrisch voneinander isolierte Anteile. Der in der Figur 2 unten dargestellte größere Anteil weist die Chipinsel auf, auf der das optoelektronische Bauelement innerhalb der Aussparung angeordnet ist. Der in der Figur 2 oben eingezeichnete Anteil des Trägerelementes 1 fungiert als weiterer elektrischer Anschluss und ist bei dem beschriebenen Ausführungsbeispiel, wie es in der Figur 1 dargestellt ist, innerhalb der Aussparung 3 mit dem Bonddraht 13 verbunden.

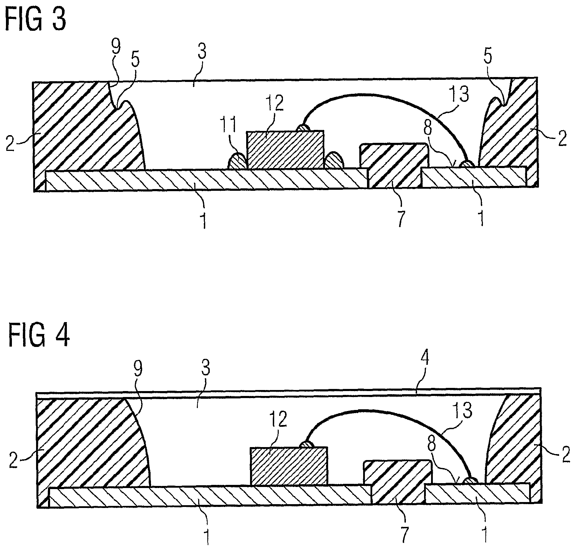

Die Figur 3 zeigt den in der Figur 1 markierten Querschnitt III durch das Gehäuse und das darin angeordnete optoelektronische Bauelement, das allerdings nur schematisch wiedergegeben ist. In der Figur 3 ist gut erkennbar, dass das Trägerelement 1 bei diesem Beispiel zwei getrennte Anteile umfasst. Die Aussparung 3 kann nach Bedarf mit einem transparenten Füllmaterial gefüllt sein. Dafür kommt z. B. eine transparente Vergussmasse, wie z. B. Silikon, ein Epoxidharz oder auch ein Hybridmaterial (Silikon-Epoxid) in Frage. Die in dem Kunststoffgehäuse 2 vorgesehene Struktur 5 ist in diesem Beispiel eine Art seitlicher Rinne in der Innenwand der Aussparung 3, die zur besseren Haftung der Vergussmasse dient.

In der Figur 3 ist außerdem ein Strukturelement 11 angedeutet, das an dem Trägerelement 1 angebracht sein kann und zur genaueren Positionierung des optoelektronischen Bauelementes 12 vorgesehen ist. Der in der Figur 1 als Beispiel dargestellte Steg 7, der bei diesem Besipiel zur Begrenzung der Anteile des Trägerelementes 1 angebracht ist, ist in der Figur 3 im Querschnitt gezeigt. Der in diesem Beispiel vorhandene Bonddraht 13 ist mit einem Ende auf einer Kontaktfläche an der Oberseite des optoelektronischen Bauelementes 12 befestigt und mit dem anderen Ende auf der Anschlussfläche 8 des zweiten Anteils des Trägerelementes 1 befestigt. Aus der dargestellten Anordnung ergibt sich, dass zur Montage in diesem Gehäuse vorzugsweise ein oberflächenemittierendes Bauelement geeignet ist. Bei einer geeignet abgewandelten Montage, z. B. insbesondere im rechten Winkel zur Oberfläche des Trägerelementes 1, kann aber auch ein kantenemittierendes Bauelement in Verbindung mit diesem Gehäuse verwendet werden.

Bei dem in der Figur 4 dargestellten weiteren Beispiel ist auf der von dem Trägerelement 1 abgewandten Seite der Aussparung 3 eine Abdeckung 4 der Öffnung 9 vorhanden. Die Abdeckung 4 ist in diesem Beispiel eine transparente Schicht aus einem mechanisch stabilen Material, z. B. aus transparentem Kunststoff oder Glas, und seitlich auf dem Kunststoffgehäuse 2 befestigt, zum Beispiel aufgeklebt. Statt dieses einfachen transparenten Deckels kann eine beliebige optische Komponente oder auch eine Anordnung mehrerer optischer Komponenten als Abdeckung 4 vorgesehen werden. Die Abdeckung 4 kann somit eine beliebige an sich bekannte Optik, zum Beispiel für Reflexion oder Diffraktion, auch in Kombination miteinander, umfassen, die auf einfache Weise an dem Kunststoffgehäuse 2 befestigt werden kann. Das ist ein besonderer Vorteil dieser Gehäusebauart. Wenn eine Abdeckung 4 vorgesehen ist, kann insbesondere auf ein Füllmaterial in der Aussparung 3 verzichtet werden.

Für eine Abdeckung 4, wie zum Beispiel einen transparenten Deckel, eine Linse oder andere optische Komponenten, wird vorzugsweise ein Material verwendet, das die für einen nachfolgenden Lötprozess, mit dem externe elektrische Anschlüsse des Gehäuses hergestellt werden, erforderlichen hohen Temperaturen unbeschadet übersteht. In der Abdeckung 4 verwendete optische Komponenten sollten bei solchen Anwendungen des Gehäuses daher insbesondere aus reflowlötfähigem Material, z. B. aus Silikon oder Glas, sein.

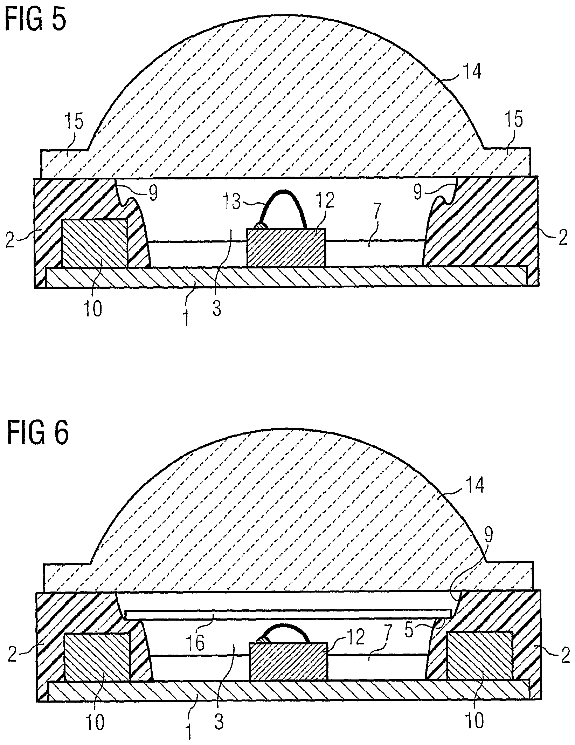

Die Figur 5 zeigt den weiteren in der Figur 1 markierten Querschnitt V für ein Ausführungsbeispiel, bei dem die Öffnung 9 der Aussparung 3 mit einer Linse 14 abgedeckt ist. In Verbindung mit der Linse 14 ist die Aussparung 3 vorzugsweise mit einem geeigneten Füllmaterial gefüllt, das Füllmaterial kann jedoch auch bei diesem Ausführungsbeispiel weggelassen sein. Die Linse kann auch als Anteil des Füllmateriales ausgebildet sein. Statt dessen kann die Linse aufgegossen oder aufgemoldet sein. Die Linse kann auch aus Glas oder einem transparenten Kunststoff bestehen. Der in der Figur 5 dargestellte randseitige Anteil 15 der Linse 14, der auf dem Kunststoffgehäuse 2 aufliegt, ist vorzugsweise mit Noppen oder Stiften versehen, die in die in der Figur 1 dargestellten Montageöffnungen 6 eingreifen, so dass die Linse 14 bei der Montage selbsttätig in der exakt justierten Position angeordnet wird.

In der Figur 5 ist noch dargestellt, dass in dem Kunststoffgehäuse 2 mindestens ein weiteres elektronisches Bauelement 10 angeordnet sein kann, das z. B. mit dem Kunststoffmaterial des Kunststoffgehäuses 2 umspritzt ist. Ein elektrischer Anschluss des weiteren elektronischen Bauelementes 10 ist z. B. über einen geeignet strukturierten Anteil eines Trägerelementes 1 aus Metall und/oder über Bonddrähte, die bei Bedarf auch aus dem Kunststoffgehäuse 2 herausgeführt sein können, möglich. Auf diese Weise können Ausgänge und/oder Eingänge des weiteren elektronischen Bauelementes mit dafür vorgesehenen Anschlüssen des optoelektronischen Bauelementes verbunden werden. Das weitere elektronische Bauelement 10 kann z. B. eine Schutzschaltung gegen Schäden durch elektrostatische Aufladung (ESD, electrostatic damage) enthalten. Es kann statt dessen oder zusätzlich eine Ansteuerschaltung für das optoelektronische Bauelement enthalten (z. B. Asic). Es können auch mehrere weitere elektronische Bauelemente in dem Kunststoffgehäuse 2 angeordnet sein. Dadurch ergibt sich eine Fülle von verschiedenen Anwendungsmöglichkeiten dieses Gehäuses. Das optoelektronische Bauelement 12 wird durch eine Anordnung eines oder mehrerer weiterer elektronischer Bauelemente innerhalb des Kunststoffgehäuses 2 in seiner Funktionsweise nicht beeinflusst oder gar beeinträchtigt. Durch die Anwesenheit eines elektronischen Bauelementes innerhalb des Kunststoffgehäuses 2 wird insbesondere keine Absorption oder Ablenkung der Strahlung bewirkt, und eine achsensymmetrische Ausgestaltung der Aussparung 3 und eine daraus resultierende achsensymmetrische Lichtabstrahlung sind problemlos möglich.

In der Figur 6 ist ein der Figur 5 entsprechender Querschnitt eines weiteren Ausführungsbeispiels dargestellt, bei dem in der Aussparung 3 ein Konversionselement 16 angeordnet ist. Als Montagehilfe für das Konversionselement 16 kann insbesondere die Struktur 5 des Kunststoffgehäuses als Stufe ausgebildet sein, so dass das Konversionselement 16 präzise zum Kunststoffgehäuse 2 hin ausgerichtet und im vorgesehenen Abstand zu dem optoelektronischen Bauelement 12 montiert werden kann. Das Konversionselement 16 ist vorzugsweise möglichst dünn und überdeckt vorzugsweise die gesamte Aussparung 3. Es besitzt vorzugsweise keine direkte Verbindung mit der Oberfläche des optoelektronischen Bauelementes 12, ist also nicht direkt auf dessen Oberfläche montiert. Dadurch kann erreicht werden, dass eine Lichtausbreitung zu oder von dem optoelektronischen Bauelement 12 mit einer praktisch richtungsunabhängigen Veränderung durch das Konversionselement 16 erfolgt. Wenn das Gehäuse für eine LED vorgesehen ist, kann mit einer solchen Anordnung des Konversionselementes 16 insbesondere gewährleistet werden, dass das in verschiedene Richtungen emittierte Licht das Konversionselement 16 unter einem zumindest näherungsweise gleichen Winkel durchquert und eine vergleichbare Weglänge zurücklegt, so dass das aus dem Gehäuse austretende Licht infolgedessen über den gesamten erfassten Raumwinkelbereich hinweg eine ähnliche Farbtemperatur aufweist. Zudem kann der Abstand des Konversionselementes 16 von dem optoelektronischen Bauelement 12 optimiert werden, so dass insbesondere die vorgesehene Lichtbündelung oder die Größe des von dem abgestrahlten Licht erfassten Raumwinkelbereiches, gegebenenfalls auch unabhängig von der Größe der Öffnung 9 der Aussparung 3, in der gewünschten Weise eingestellt werden kann. Die Gehäusebauart erlaubt es somit, die Anordnung aus optoelektronischem Bauelement 12 und Konversionselement 16 den jeweiligen Anforderungen entsprechend zu optimieren. Die Fixierung des Konversionselementes 16 im vorgesehenen Abstand zu dem optoelektronischen Bauelement 12 kann bei Verwendung eines Füllmaterials, mit dem die Aussparung 3 gefüllt wird, zum Beispiel in der Weise bewerkstelligt werden, dass das Füllmaterial zunächst bis zu einer bestimmten Höhe in die Aussparung 3 eingebracht wird, das Konversionselement 16 auf diesem Anteil des Füllmaterials angeordnet wird und schließlich das restliche Füllmaterial eingebracht und das Konversionselement 16 darin eingeschlossen wird.

Bei dem Ausführungsbeispiel gemäß der Figur 6 befinden sich in dem dargestellten Querschnitt zwei elektronische Bauelemente 10 innerhalb des Kunststoffgehäuses 2. Damit soll verdeutlicht werden, dass in dem Kunststoffgehäuse 2 mehrere elektronische Bauelemente 10 an derselben Seite des Kunststoffgehäuses 2 oder auch an verschiedenen Seiten angeordnet sein können.

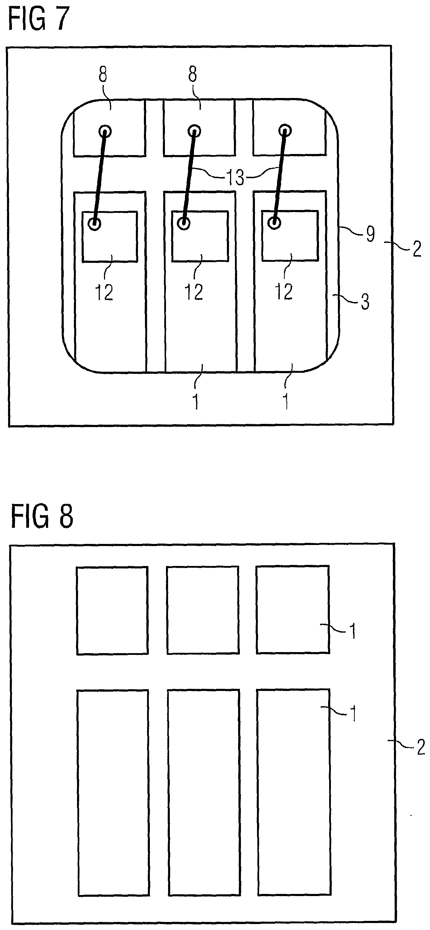

Die Figur 7 zeigt ein weiteres Ausführungsbeispiel des Gehäuses in einer Aufsicht entsprechend der Figur 1. Bei diesem Ausführungsbeispiel ist das Trägerelement 1 in mehrere Anteile unterteilt, so dass mehrere optoelektronische Bauelemente 12 darauf angeordnet und elektrisch angeschlossen werden können. In dem dargestellten Ausführungsbeispiel sind drei optoelektronische Bauelemente 12, z. B. Leuchtdioden, in der Aussparung 3 angeordnet. Jedes optoelektronische Bauelement 12 ist auf einem separaten Anteil des Trägerelementes 1 angeordnet und über einen jeweiligen Bonddraht 13 mit einer separaten Anschlussfläche 8 verbunden. Die Form der Öffnung 9 ist an die Anordnung mehrerer optoelektronischer Bauelemente 12 angepasst. Die Anzahl der montierten optoelektronischen Bauelemente 12 ist durch die Größe der Bauelemente und die Größe der Aussparung 3 eingeschränkt, aber ansonsten beliebig.

Die Figur 8 zeigt das Ausführungsbeispiel gemäß der Figur 7 in einer der Figur 2 entsprechenden rückseitigen Aufsicht, in der die Unterteilung des Trägerelementes 1 in die separaten Anteile erkennbar ist.

Die in Verbindung mit dem Gehäuse verwendeten verschiedenen elektronischen und optischen Komponenten können auf einfache Weise montiert werden. Die Verwendung lötstabiler Optiken erlaubt eine hochwertige Verbindung mit dem Kunststoffgehäuse, bevor das Gehäuse zum Beispiel auf einer Platine oder dergleichen montiert wird und Lötkontakte hergestellt werden. Da das Gehäuse sehr klein dimensioniert werden kann, können die Optiken ebenfalls klein gestaltet und die Herstellungskosten gesenkt werden. Das Gehäuse ist nahezu beliebig dimensionierbar, so dass sich insbesondere dessen Bauhöhe an die Größe des optoelektronischen Bauelementes anpassen lässt.

## Patentansprüche

1. Gehäuse für ein optoelektronisches Bauelement mit
einem Trägerelement (1) mit einer Oberseite, das eine strukturierte Metallschicht in Form eines ebenen metallischen Leadframes, der lediglich gestanzt oder geätzt ist, mit mindestens zwei voneinander getrennten und elektrisch isolierten Anteilen ist,
einem Kunststoffgehäuse (2), das auf dem Trägerelement (1) angeordnet ist, und
einer Aussparung (3) in dem Kunststoffgehäuse (2),
wobei
die Aussparung (3) Abmessungen aufweist, die die Aufnahme des optoelektronischen Bauelementes auf der Oberseite des Trägerelements (1) erlauben,
die Aussparung (3) auf der von dem Trägerelement (1) abgewandten Seite eine Öffnung (9) besitzt und sich von der Öffnung (9) bis zum Trägerelement (1) erstreckt,
das Kunststoffgehäuse (2) ein mit einem Kunststoffmaterial des Kunststoffgehäuses (2) umspritztes, in seinem Inneren angeordnetes weiteres, elektronisches Bauelement (10) umfasst, das eine Schutzschaltung gegen Schäden durch elektrostatische Aufladung und/oder eine Ansteuerschaltung für das optoelektronische Bauelement (12) enthält,
das Kunststoffgehäuse (2) aus einem schwarzen Duroplast und an den thermischen Ausdehnungskoeffizienten des Trägerelements (1) angepasst ist,
die mindestens zwei Anteile des Trägerelements (1) durch einen Steg (7) voneinander getrennt und elektrisch isoliert sind, wobei der Steg (7) von einem Anteil des Kunststoffgehäuses (2) gebildet wird und über die Oberseite des Trägerelements (1) ragt, und
das Trägerelement (1) auf der dem Kunststoffgehäuse (2) abgewandten Seite rückseitige Kontaktflächen für einen externen elektrischen Anschluss und keine nach außen geführten Anschlussbeinchen aufweist und das Kunststoffgehäuse (2) in allen entlang der rückseitigen Kontaktflächen verlaufenden Richtungen an die Kontaktflächen angrenzt, so dass das Gehäuse eine no-leads-Bauform ist.

2. Gehäuse nach Anspruch 1, bei dem
eine transparente Abdeckung (4) der Öffnung (9) der Aussparung (3) vorhanden ist.

3. Gehäuse nach Anspruch 2, bei dem
die transparente Abdeckung eine Linse (14) umfasst.

4. Gehäuse nach einem der Ansprüche 1 bis 3, bei dem ein transparentes Füllmaterial in der Aussparung (3) vorhanden ist.

5. Gehäuse nach Anspruch 4, bei dem
das Kunststoffgehäuse (2) mit einer Struktur (5) versehen ist, die eine Rinne in der Innenwand der Aussparung (3) ist und dem Anhaften des Füllmaterials dient.

6. Gehäuse nach einem der Ansprüche 1 bis 5, bei dem
das Kunststoffgehäuse (2) mit einer Struktur (5), die eine Stufe in der Innenwand der Aussparung (3) ist, oder einer Montageöffnung (6) versehen ist, die die Anordnung einer Abdeckung (4) oder einer optischen Komponente relativ zu dem Kunststoffgehäuse (2) festlegt.

7. Gehäuse nach einem der Ansprüche 1 bis 6, bei dem
das Trägerelement (1) eine Chipinsel oder ein Strukturelement (11) aufweist, das zur Aufnahme eines optoelektronischen Bauelementes (12) innerhalb der Aussparung (3) vorgesehen ist.

8. Anordnung eines optoelektronischen Bauelementes in einem Gehäuse gemäß einem der Ansprüche 1 bis 7, mit einem optoelektronischen Bauelement (12), insbesondere einer Leuchtdiode, das mit einem für Lichtemission oder Lichtrezeption vorgesehenen Bereich zu der Öffnung (9) hin ausgerichtet innerhalb der Aussparung (3) angeordnet ist.

9. Anordnung nach Anspruch 8, bei der
ein Konversionselement (16) zwischen der Öffnung (9) der Aussparung (3) und dem optoelektronischen Bauelement (12) angeordnet ist.

10. Anordnung nach Anspruch 9, bei der
das Konversionselement (16) den gesamten durch die Öffnung (9) der Aussparung (3) bestimmten Raumwinkelbereich überspannt, so dass das Konversionselement (16) eine richtungunabhängige Veränderung der Lichtausbreitung zu oder von dem in der Aussparung (3) angeordneten optoelektronischen Bauelement (12) bewirkt.

11. Anordnung nach einem der Ansprüche 8 bis 10, bei der mindestens ein weiteres optoelektronisches Bauelement (12), insbesondere eine Leuchtdiode, vorhanden ist, das mit einem für Lichtemission oder Lichtrezeption vorgesehenen Bereich zu der Öffnung (9) hin ausgerichtet innerhalb der Aussparung (3) angeordnet ist.

## Claims

1. Housing for an optoelectronic device having
a carrier element (1) having an upper surface, the carrier element being a structured metal layer in the form of a planar metallic lead frame, which is merely stamped or etched, with at least two parts which are separated from one another and electrically insulated from one another,
a plastic housing (2) which is arranged on the carrier element (1), and
a recess (3) in the plastic housing (2),
wherein
the recess (3) has dimensions which allow the optoelectronic component to be accommodated on the upper surface of the carrier element (1),
the recess (3) has an opening (9) on the side remote from the carrier element (1) and extends from the opening (9) to the carrier element (1),
the plastic housing (2) comprises a further electronic component (10) being encapsulated with a plastic material of the plastic housing (2), the electronic component being arranged in its interior and containing a protective circuit against damage by electrostatic charging and/or a drive circuit for the optoelectronic component (12),
the plastic housing (2) is made of a black thermosetting plastic and is adapted to the coefficient of thermal expansion of the carrier element (1),
the at least two parts of the carrier element (1) are separated from one another by a web (7) and are electrically insulated, the web (7) being formed by a part of the plastic housing (2) and projecting beyond the upper side of the carrier element (1), and
the carrier element (1) has rear contact surfaces on the side remote from the plastic housing (2) for an external electrical connection and no outwardly guided connection legs, and the plastic housing (2) adjoins the contact surfaces in all directions running along the rear contact surfaces, so that the housing is a no-leads design.

2. Housing according to claim 1, wherein
a transparent cover (4) of the opening (9) of the recess (3) is provided.

3. Housing according to claim 2, wherein
the transparent cover comprises a lens (14).

4. Housing according to any of claims 1 to 3, wherein
a transparent filling material is provided in the recess (3).

5. Housing according to claim 4, wherein
the plastic housing (2) is provided with a structure (5) which is a channel in the inner wall of the recess (3) and serves to adhere the filling material.

6. Housing according to any of claims 1 to 5, wherein
the plastic housing (2) is provided with a structure (5) which is a step in the inner wall of the recess (3) or a mounting opening (6) defining the arrangement of a cover (4) or an optical component relative to the plastic housing (2).

7. Housing according to any of claims 1 to 6, wherein
the carrier element (1) has a chip island or a structural element (11) which is provided for receiving an optoelectronic component (12) within the recess (3).

8. Arrangement of an optoelectronic component in a housing according to any of claims 1 to 7, with
an optoelectronic component (12), in particular a light-emitting diode, which is arranged within the recess (3) with a region provided for light emission or light reception aligned towards the opening (9).

9. Arrangement according to claim 8, wherein
a conversion element (16) is arranged between the opening (9) of the recess (3) and the optoelectronic component (12).

10. Arrangement according to claim 9, wherein
the conversion element (16) spans the entire solid angle range determined by the opening (9) of the recess (3), so that the conversion element (16) effects a direction-independent change in the light propagation to or from the optoelectronic component (12) arranged in the recess (3) .

11. Arrangement according to any of claims 8 to 10, wherein at least one further optoelectronic component (12), in particular a light-emitting diode, is provided, which is arranged within the recess (3) with a region provided for light emission or light reception aligned towards the opening (9).

## Revendications

1. Boîtier pour un composant optoélectronique, avec
un élément porteur (1) avec une face supérieure, qui est une couche métallique structurée sous la forme d'une grille de connexion métallique plane, qui est uniquement estampée ou corrodée, avec au moins deux parts séparées l'une de l'autre et isolées électriquement,
un boîtier en plastique (2) qui est disposé sur l'élément porteur (1), et
un évidement (3) dans le boîtier en plastique (2),
sachant que,
l'évidement (3) présente des dimensions, qui permettent le logement du composant optoélectronique sur la face supérieure de l'élément porteur (1),
l'évidement (3) possède une ouverture (9) sur la face détournée de l'élément porteur (1), et s'étend de l'ouverture (9) jusqu'à l'élément porteur (1),
le boîtier en plastique (2) comporte un autre composant électronique (10) disposé dans son intérieur et extrudé avec une matière en plastique du boîtier en plastique (2), qui contient un circuit protecteur contre les détériorations issues d'une charge électrostatique et/ou un circuit de commande pour le composant optoélectronique (12),
le boîtier en plastique (2) est en un plastique thermodurcissable noir et adapté aux coefficients d'extension thermiques de l'élément porteur (1),
les au moins deux parts de l'élément porteur (1) sont séparées l'une de l'autre par une traverse (7) et isolées électriquement, la traverse (7) étant constituée par une part du boîtier en plastique (2) et faisant saillie au-dessus du côté supérieur de l'élément porteur (1), et
l'élément porteur (1) présente sur le côté détourné du boîtier en plastique (2) des surfaces de contact à l'arrière pour un branchement électrique externe et aucune patte de connexion guidée vers l'extérieur et que le boîtier en plastique (2) est adjacent aux surfaces de contact dans toutes les directions se produisant le long des surfaces de contact arrière, de sorte que le boîtier est une construction no-leads.

2. Boîtier selon la revendication 1,
pour lequel un recouvrement transparent (4) de l'ouverture (9) de l'évidement (3) est présent.

3. Boîtier selon la revendication 2,
pour lequel le recouvrement transparent présente une lentille (14) .

4. Boîtier selon une quelconque des revendications 1 à 3, pour lequel une matière de charge transparente est présente dans l'évidement (3).

5. Boîtier selon la revendication 4, pour lequel
le boîtier en plastique (2) est doté d'une structure (5), qui est une rainure dans la paroi interne de l'évidement (3) et sert à l'adhérence de la matière de charge.

6. Boîtier selon une quelconque des revendications 1 à 5, pour lequel
le boîtier en plastique (2) est doté d'une structure (5), qui est un gradin dans la paroi interne de l'évidement (3) ou d'une ouverture de montage (6), qui définit la disposition d'un recouvrement (4) ou d'un composant optique par rapport au boîtier en plastique (2).

7. Boîtier selon une quelconque des revendications 1 à 6, pour lequel
l'élément porteur (1) présente un îlot de puce électronique ou un élément de structure (11) qui est prévu pour le logement du composant optoélectronique (12) à l'intérieur de l'évidement (3) .

8. Disposition d'un composant optoélectronique dans un boîtier selon une quelconque des revendications 1 à 7, avec un composant optoélectronique (12), notamment une diode luminescente, qui est disposée à l'intérieur de l'évidement (3) avec une zone orientée vers l'ouverture (9) et prévue pour l'émission de lumière ou la réception de lumière.

9. Disposition selon la revendication 8, pour laquelle un élément de conversion (16) est disposé entre l'ouverture (9) de l'évidement (3) et le composant optoélectronique (12).

10. Disposition selon la revendication 9, pour laquelle l'élément de conversion (16) recouvre l'ensemble de la zone d'angle solide définie par l'ouverture (9) de l'évidement (3), de sorte que l'élément de conversion (16) entraîne une modification de la diffusion de lumière indépendante de la direction, vers ou à partir du composant optoélectronique (12) disposé dans l'évidement (3).

11. Disposition selon une quelconque des revendications 8 à 10, pour laquelle
au moins un autre composant optoélectronique (12), notamment une diode luminescente, est présente, qui est disposée à l'intérieur de l'évidement (3) avec une zone orientée vers l'ouverture (9) et prévue pour l'émission de lumière ou la réception de lumière.
